# EUROPEAN PATENT APPLICATION

(11) **EP 1 032 038 A2**
(43) Date of publication of application: **30.08.2000**
(21) Application number: 00102225.0
(22) Date of filing: 11.02.2000
(51) Int. Cl.: H01L 23/498, H01L 23/29

(54) **Conductive and resitive material with electrical stability for use in electronics devices**

(30) Priority: 12.02.1999 US 249927
(71) Applicant: National Starch and Chemical Investment Holding Corporation, Wilmington, Delaware 19803-7663 (US)
(72) Inventor: Tong, Quinn, Belle Mead, New Jersey 08602 (US); Yue Xiao, Allison, Sommerville, New Jersey 08876 (US); Lu, Daoqiang, Atlanta, Georgia 30318 (US)
(74) Representative: Held, Stephan, Dr.rer.nat., Dipl.-Chem.

(57) **Abstract**

An composition with improved electrical stability for use in microelectronic applications comprises a polymeric resin, a conductive filler, optionally either a reactive or a nonreactive diluent, optionally an inert filler, and an oxygen scavenger or corrosion inhibitor or both to provide the electrical stability.

## Description

This invention relates to compositions that are suitable for use as conductive or resistive materials in microelectronic devices or semiconductor packages to provide electrically stable interconnections.

Conductive and resistive compositions are used for a variety of purposes in the fabrication and assembly of semiconductor packages and microelectronic devices. For example, conductive adhesives are used to bond integrated circuit chips to substrates (die attach adhesives) or circuit assemblies to printed wire boards (surface mount conductive adhesives), and resistive materials are used to form planar or buried resistors in circuit boards.

These compositions, however, are vulnerable to environmental conditions, and high temperature and high humidity can cause the electrical resistance of the assembly fabricated with these compositions to increase substantially over time. The suspected mode of failure is electrochemical corrosion of the circuitry at the interface of the conductive filler in the composition with another contiguous metal surface, for example, a metal lead frame or other circuitry.

Two conductors with dissimilar electrochemical potentials will form an electrochemical cell in the presence of water. The conductors act as cathode and anode, and environmental humidity provides the necessary aqueous medium to bridge the anode and cathode. The metal with the higher electrochemical potential acts as the cathode {2H₂O + O₂ + 4*e* → 4OH⁻}. The metal with the lower electrochemical potential acts as the anode resulting in the loss of electrons {M - n*e* → Mⁿ⁺} and the corrosion of the metal. Oxygen is involved in this mechanism but does not directly react with the anode metal. The metal ion Mⁿ⁺ will combine with OH⁻ and form a metal hydroxide that stabilizes by developing into a metal oxide, which over time forms on the anode surface. Metal oxides in general are non-conductive, the result being a decrease in conductivity of the metal circuitry.

The problem is less acute when the filler in the composition is the same metal as the contiguous circuitry or the substrate. Thus, a semiconductor package using a conductive composition, one comprising an epoxy resin and silver filler, for example, will not be as susceptible to eleotrochemical failure when a silver-filled composition is used on a silver substrate. However, if the composition is used on a nickel plated substrate, electrochemical corrosion will result under high humidity conditions. If the composition is a resistive composition containing carbon black as the filler, corrosion will become a problem under high humidity conditions if the substrate contains metal with a low electrochemical potential, such as Ni, Cu, and Sn/Pb solder.

It would be an advantage, therefore, to provide conductive and resistive materials that form electrically stable assemblies for use in semiconductor packaging operations.
Figure 1 is a graph of the effect of oxygen scavengers on the contact resistivity of Composition D after exposure to 85°C and 85% relative humidity for 500 hours.
Figure 2 is a graph of the effect of corrosion inhibitors on the contact resistivity of Composition D after exposure to 85°C and 85% relative humidity for 500 hours.
Figure 3 is a drawing of the test vehicle for bulk resistance.
Figure 4 is a drawing of the test vehicle for contact resistance.

This invention is a composition that comprises a polymeric resin, a conductive filler, an oxygen scavenger or corrosion inhibitor or both, optionally other additives such as reactive or nonreactive diluents, inert fillers, and adhesion promoters. The compositions exhibit improved electrical stability over those compositions that do not contain an oxygen scavenger or corrosion inhibitor. The oxygen scavengers or corrosion inhibitors will be present in an amount up to 10 weight percent (but not 0%); the resin will be present in an amount of 10 to 90 weight percent: the filler, in an amount of 1 to 90 weight percent; the diluent, in an amount of 0 to 50 weight percent; the inert fillers, in an amount of 0 to 80 weight percent; and the adhesion promoters, in an amount of 0 to 10 weight percent, for a total of 100 weight percent.

In another embodiment, this invention is a method for improving the electrical stability of a composition by adding one or more oxygen scavengers, one or more corrosion inhibitors, or one or more oxygen scavengers and corrosion inhibitors to the composition.

Chemical compositions that may be used in the fabrication of semiconductor packages can be given improved electrical stability by the addition of an oxygen scavenger or corrosion inhibitor or both to the formulation. Although oxygen scavengers and corrosion inhibitors have been used in aqueous medium to inhibit corrosion, it was unexpected that these materials could be added to compositions for use in the electronics industry without any loss in initial conductivity or adhesion properties of these compositions.

A conductive composition achieves its conductivity through metal particles dispersed throughout the composition. When these metal particles are in contact with another contiguous metal, as is required to form the circuitry for the ultimate electronic device, and water is present, an electrochemical cell is formed. The reaction at the cathode utilizes oxygen, and the reaction at the anode eventually produces a metal oxide.

Applicants have discovered that the presence of an oxygen scavenger in the conductive composition to impede the cathodic reaction, or alternatively, the presence of a compound to chelate or react with the metal anode or cathode to interfere with the electrical pathway, will reduce or prevent the electrochemical process and prevent significant increases in resistivity.

An oxygen scavenger is defined herein to be any chemical compound that will react with oxygen to prevent the oxygen from further reaction at the electrochemical cell cathode. Exemplary oxygen scavengers are hydroquinone, carbohydrazide, trihydroxybenzene, aminophenol, hydrazine, pyrogallol, carbohydrazone, polyethyleneamine, cyclohexanedione, hydroxylamine, methoxypropylamine, cyclohexylamine, diethylethanolamine, hydroxyalkylhydroxylamine, tetrasubstituted phenylenediamines, morpholinohexose reductone, keto-gluconates, amine bisulfites, lactone derivatives, phenol derivatives, and substituted quinolines.

A corrosion inhibitor is defined herein to be any chemical compound that has a lone pair of electrons, such as nitrogen-, sulfur-, and oxygen-containing compounds, that will bind with metal and impede the reactivity of the metal at the electrochemical anode. Exemplary corrosion inhibitors are 1,10-phenathiodine, phenothiazine, benzothriazole, benzimidazole, mercaptobenzothiazole, dicyandiamide, 3-isoprolyamino-1-butyne, propargyl quinolinium bromide, 3-benzylamino-1-butyne, dipropargl ether, dipropargyl thioether, propargyl caproate, dianimoheptane, phenathroline, amine, diamine, triamine, hexamethyleneimide, decamethyleneimide, hexamethyleneiminebenzoate, hexamethyleneimine-3,5-dinitrobenzoate, hexamethylenetetramin, d-oximino-b-vinyl quinuolidine, aniline, 6-N-ethyl purine, 1-ethylamino-2-octadecylimidazoline, morpholine, ethanolamine, aminophenol, 8-hydroxyquinoline, pyridine and its derivatives, quinoline and its derivatives, acridine, imidazole and its derivatives, toluidine, mercaptan, thiophenol and its derivates, sulfide, sulfoxide, thiophosphate, and thiourea.

As will be recognized, some oxygen scavengers have corrosion inhibition capability, and some corrosion inhibitors have oxygen scavenger ability.

Exemplary resins for use in these formulations are any of the resins currently used throughout the industry, such as, vinyl, acrylic, phenolic, epoxy, maleimide, polyimide, or silicon-containing resins. The formulations and physical properties are known to those skilled in the art.

Exemplary reactive diluents are glycidyl ethers, for example, 1,4-butanediol diglycidyl ether; vinyl ethers, for example, ethylene vinyl ether, and vinyl esters, for example, ethylene vinyl ester, and acrylates, for example, methyl methacrylate.

An exemplary nonreactive diluents is butyl carbitol.

Exemplary adhesion promoters are silanes and polyvinyl butyrol.

Chemical compositions are used in the fabrication of electronic packages, for example, as adhesives, encapsulants, or to form integral passives, such as resistors or capacitors. By the judicious choice of filler, these compositions can be formulated to give a broad range of resistivity, conductivity, capacitance, or dielectric properties as needed for the specific circuit component. Providing the precise type and amount of filler for obtaining the electrical properties desired for a specific end use application is within the expertise of one skilled in the art. It will be understood that all resistors necessarily exhibit some conductance, and all conductors exhibit some resistance, and that resistors and conductors form a continuum of resistance and conductance depending on the specific property of the individual material. This continuum is also the case for dielectrics and capacitors. A dielectric may function as a true dielectric or isolating component, or as a capacitor, depending on the specific dielectric constant.

Exemplary conductive fillers are silver, copper, gold, palladium, platinum, carbon black, carbon fiber, graphite, aluminum, and antimony doped tin oxide. Exemplary inert fillers include talc, silica, silicate, aluminum nitride, and mica. Exemplary capacitance/dielectric fillers, which also will be deemed inert fillers herein, are ceramic, barium titanate, and titantium dioxide.

In another embodiment, this invention is a method of enhancing the electrical stability of a conductive or resistive composition comprising adding to the composition an oxygen scavenger or corrosion inhibitor or both.

The invention can be further described by the following examples.

### EXAMPLES

EXAMPLE 1. Three compositions designated A-C were prepared from a phenolic resin and varying amounts of carbon black. The compositions had the following formulations set out in Table 1:

**Table 1**

| Composition A | Composition B | Composition C |
|---|---|---|
| Fillers: | Fillers: | Fillers: |
| 15g carbon black | 8g carbon black | 2g carbon black |
| 21g talc | 21g talc | 21g talc |
| 1g silica | 1g silica | 1g silica |

| Resin: | Resin: | Resin: |
|---|---|---|
| 54g phenolic resin | 54g phenolic resin | 54g phenolic resin |
| 6g polyvinyl butyral | 6g polyvinyl butyral | 6g polyvinyl butyral |

| Diluent: | Diluent: | Diluent: |
|---|---|---|
| 15-20g butyl carbitol | 15-20g butyl carbitol | 15-20g butyl carbitol |

The fillers were mixed together by a kneader or planetary mixer. The phenolic resin was a xylene-formaldehyde resin available from Emerson & Cuming; the resin components were mixed together and slowly added with mixing to the fillers. The resulting paste was dispersed and blended with a three roll mill until the paste became uniform. The viscosity was adjusted with butylcarbitol to 0.6 Pa.s at 25°C as measured by a Brookfield viscometer using a #14 spindle at 5 rpm.

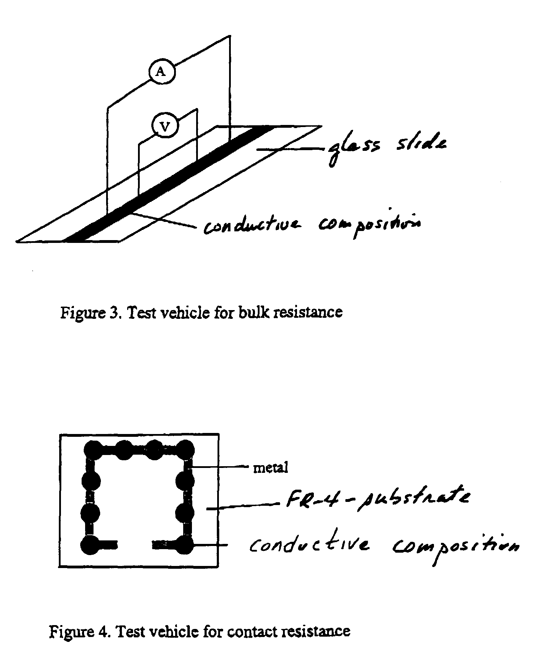

Composition A was measured for its resistivity without contact with any contiguous metal, denominated its bulk resistivity. The resistivity test vehicle, shown in Figure 3, consisted of the test composition cured on a glass slide. The composition was dispensed along the length of the slide 78 mm, in an approximate thickness of 20 µm, and width of 4mm, and then cured for 4 hours at 175° C. After cure, the resistivity was measured using a four probe GenRad 1689 Precision RLC Digibridge. In Figure 3, A stands for electrical current and V stands for electrical voltage.

The test specimen was then subjected to 85°C and 85% relative humidity for 500 hours, after which resistivity was again measured. The results indicated only a minor change in resistivity.

EXAMPLE 2. This example demonstrates the effect of temperature and humidity on the resistivity of Compositions A, B, and C, when contacted with a contiguous metal, denominated contact resistivity.

The contact resistivity test vehicle, shown in Figure 4, consisted of a FR-4 board substrate on which was printed a pattern of an open circuit with metal segments 3mm long separated by 1 mm gaps in a horseshoe shape. The number of connections between the composition and the metal segments was ten. The compositions were cured for 4 hours at 175°C.

By using multiple metal-adhesive connections in the contact resistance device, the conductivity change can be magnified and the experimental error minimized. Contact resistance was measured across the circuit using a Fluke 45 Dual Display Multimeter and was deemed to be the combination of the resistance as determined by resistivity plus the interfacial resistance between the end of each metal segment and the test composition.

Contact resistance values were determined directly after cooling to room temperature after curing, and monitored over the course of 500 hours while begin subjected to 85°C and 85% relative humidity.

The percent increase In contact resistivity for the A, B, and C compositions are reported in Table 2.

**Table 2**

| Percent Increase in Contact Resistivity for Compositions With No Oxygen Scavenger or Corrosion Inhibitor | | | |
|---|---|---|---|
| Composition | Initial contact resistivity Ω/cm | Contact resistivity after 85°/85 RH for 500 hours Ω/cm | Percent Increase in resistivity % |
| A | 100 | 1506 | 1506 |
| B | 1000 | 13720 | 1272 |
| C | 10000 | 54700 | 447 |

To test for the effectiveness of the addition of an oxygen scavenger on resistance stability, each of the Compositions A, B, and C was doped with 7 weight percent hydroquinone. The contact resistivity was tested both before and after conditioning at 85°C/85%RH. The results are reported in Table 3 and show a significant improvement in the electrical stability of the compositions when doped with an oxygen scavenger.

**Table 3**

| Compositions with 7 Weight Percent Hydroquinone | | | |
|---|---|---|---|
| Composition | Initial contact resistivity Ω/cm | Contact resistivity after 85°/85 RH for 500 hours Ω/cm | Percent Increase in resistivity % |
| A | 90 | 120 | 34 |
| B | 1180 | 3705 | 214 |
| C | 9000 | 19260 | 114 |

EXAMPLE 3. A series of compositions were prepared from Composition A of Example 1, doped with varying amounts of an oxygen scavenger or corrosion inhibitor. The contact resistivity was measured as in Example 2 both before and after conditioning at 85°C/85% Relative Humidity. The results are reported in Table 4 and show that, with the exception of mercaptobenzothiazole, the presence of the oxygen scavenger or corrosion inhibitor effectively prevents significant increase in resistivity.

**Table 4**

| Change in Joint Resistivity | | | |
|---|---|---|---|
| Composition A | Initial contact resistivity Ω/cm | Contact resistivity after 85/85 Ω/cm | Percent Increase % |
| with no oxygen scavenger or corrosion inhibitor | 100 | 1506 | 1506 |
| with 2 wt % hydroquinone | 108 | 1016 | 841 |
| with 2 wt % dicyandiamide | 90 | 104 | 15 |
| with 5 wt % dicyandiamide | 112 | 138 | 23 |
| with 2 wt % diaminoheptane | 150 | 1371 | 814 |
| with 5 wt % diaminoheptane | 180 | 295 | 64 |
| with 5 wt % benzimidazole | 80 | 98 | 22 |
| with 5 wt % phenathroline | 87 | 144 | 65 |
| with 5 wt % phenothiazine | 60 | 95 | 59 |
| with 5 wt % benzotriazole | 104 | 531 | 411 |
| with 5 wt % mercaptobenzothiazole | 2662 | 268862 | 10000 |

EXAMPLE 4. Several compositions suitable for attaching semiconductor dies to lead frames or for attaching semiconductor packages to circuit boards were prepared with oxygen scavengers and corrosion inhibitors and tested for die shear strength. The basic formulation, Composition D, contained 1.0g of a bisphenol F epoxy resin from Shell Chemical Company, 0.12g of a urea catalyst, and 4g silver flakes. The oxygen scavenger or corrosion inhibitor was added in the amount of 0.05g to this Composition D. An aliquot of the composition was dispensed on a copper substrate, and a 80milX80mil silicon die contacted with the composition with heat (150°C) for 60 minutes and light pressure. Die shear strength was measured in kg using a Royce system 552 instrument. Eight specimens were tested for each composition and the results pooled and averaged. The results are shown in Table 5. The data show that the addition of an oxygen scavenger does not adversely affect the adhesion properties of the compositions.

**Table 5**

| Die Shear Strength | |
|---|---|
| COMPOSITION D | 12.23 kg |
| with 5% carbohydrazide | 10.65 kg |
| with 5% hydroquinone | 12.83 kg |
| with 5% propyl gallate | 13.36 kg |
| with 5% 8-hydroxyquoline | 14.06 kg |
| with 5% 1,10-phenanthroline | 10.86 kg |

EXAMPLE 5. The five compositions from Example 4 were tested for change in contact resistivity after 85°C/85% RH conditioning over a period of 500 hours as in the previous examples, except Sn/Pb solder was used instead of copper. Three specimens for each were tested and the results pooled and averaged. The percent increase in resistivity after conditioning is reported in Table 6 for each of the samples. The data show that an oxygen scavenger or corrosion inhibitor can be used to provide electrical stability by preventing increases in resistivity.

**Table 6**

| Change in Joint Resistivity | | | |
|---|---|---|---|
| Composition | Initial contact resistivity Ω/cm | Contact resistivity after 85/85 Ω/cm | Change in contact resistivity Ω/cm |
| Composition D | 1.85 | 13.06 | 11.21 |
| with 5% carbohydrazide | 0.71 | 1.50 | 0.79 |
| with 5% hydroquinone | 1.09 | 7.87 | 6.78 |
| with 5% propyl gallate | 2.76 | 13.76 | 11.0 |
| with 5 weight % 8-hydroxyquinoline | 0.53 | 1.02 | 0.49 |
| with 5 weight % 1,10-phenanthroline | 0.74 | 2.19 | 1.45 |

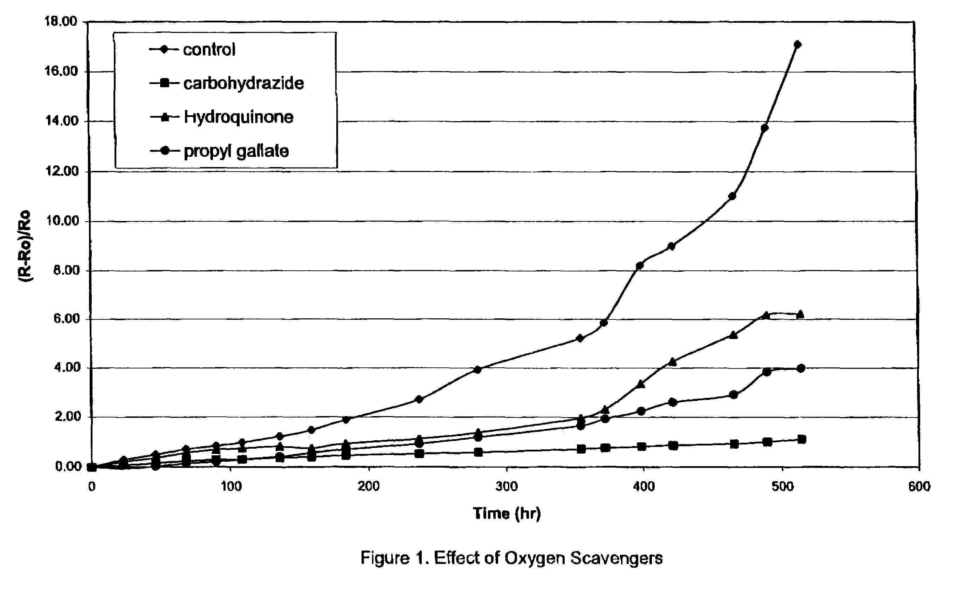

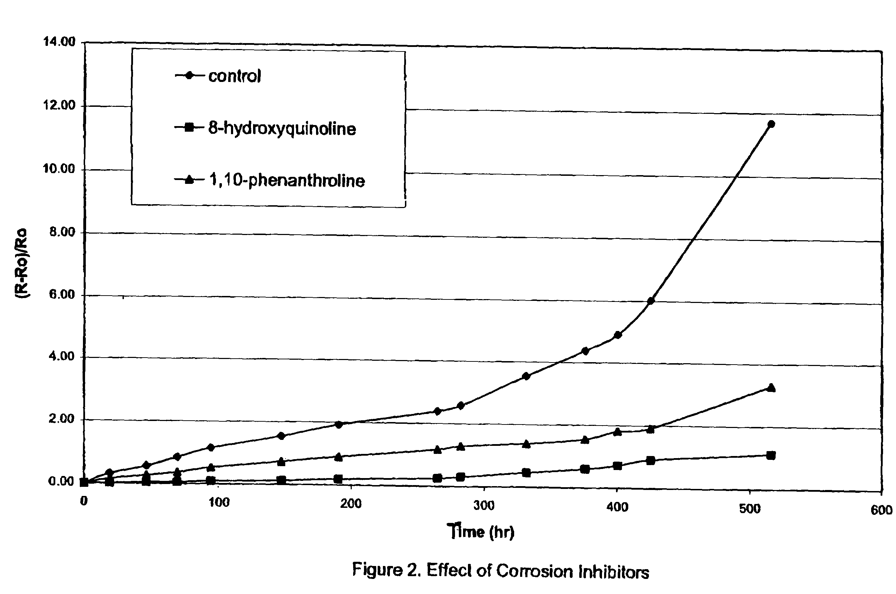

The results are also shown in graph format in Figures 1 and 2, in which change in resistivity is plotted along the Y-axis and time in hours is plotted along the X-axis. R denotes resistivity during the 85°/85%RH conditioning, R₀ denotes initial resistivity before conditioning. Figure 1 shows the graph for the compositions doped with the oxygen scavenger, and Figure 2, for the compositions doped with corrosion inhibitors. The graphs show that the doped compositions exhibit a much lower increase in resistivity over time at 85°C/85%RH than the control compositions without any oxygen scavenger or corrosion inhibitor.

EXAMPLE 6: To test for retention of adhesion in the presence of oxygen scavengers or corrosion inhibitors, samples were prepared from Composition A and doped with varying weight percents of an oxygen scavenger or corrosion inhibitor. The test compositions were prepared for resistivity testing as in Example 1. Initial resistivity along the strip of composition was measured after cure using a GenRad 1689 Precision RLC Digibridge. A strip of Scotch® 810 adhesive tape was placed along the entire length of the pattern of composition on the glass slide with the adhesive contacting the composition. A 1.5kg weight was rolled over the tape 6 times. The glass slide was secured in a vertical position and an end of the tape pulled from the composition and allowed to hang vertically down from the glass slide. A 500 g weight was attached to the end of the tape and allowed to fall and peel the tape from the glass slide. The resistance was then remeasured.

The same procedure was repeated for compositions deposited on a polyimide film commercially available as Kepton® film from DuPont.

The test compositions and change in resistance are reported in Table 7

**Table 7**

| Percentage Change in Resistivity after Peel Test | | |
|---|---|---|
| COMPOSITION | On glass slide % change | On polyimide film % change |
| Composition A | 0.1 | 0.9 |
| with 2 weight% hydroquinone | 0.3 | -0.3 |
| with 7 weight% hydroquinone | 0.4 | -1.1 |
| with 2 weight% dicyandiamide | 0.3 | 0.8 |
| with 5 weight% dicyandiamide | 0.7 | 2623 |
| with 2 weight% diaminoheptane | 0.6 | -1.9 |
| with 5 weight% diaminoheptane | 0.5 | 1.6 |
| with 5 weight% benzimidazole | 0.3 | 174.4 |
| with 5 weight% phenathroline | 0.1 | -1.0 |
| with 5 weight% phenothiazine | 0.0 | 0.2 |
| with 5 weight% benzotriazole | 0.2 | 1815 |

The data show that, except for a few specimens with higher loading on polyimide film, there are only minor changes in resistance after the adhesion test, indicating good retention of adhesion for the compositions containing oxygen scavengers or corrosion inhibitors.

## Claims

1. In a composition for use in microelectronic devices comprising
(a) a polymeric resin,
(b) a conductive filler,
(c) optionally, a reactive or a nonreactive diluent,
(d) optionally, an inert filler, and
(e) optionally, an adhesion promoter,
an improvement comprising the addition to the composition of an oxygen scavenger or corrosion inhibitor or both.

2. The composition according to claim 1 in which
(a) the polymeric resin is present in an amount of 10 to 90 weight percent and is are selected from the group consisting of vinyl-, acrylic-, phenol-, epoxy-, maleimide-, polyimide-, or silicon-containing resins:
(b) the conductive filler is present in an amount of 1 to 90 weight percent and is selected from the group consisting of silver, copper, gold, palladium, platinum, carbon black, carbon fiber, graphite, aluminum, and antimony doped tin oxide.
(c) the diluent is present in an amount of 0 to 50 weight percent and is selected from the group consisting of 1,4-butanediol diglycidyl ether and butyl carbitol.
(d) the inert fillers are present in an amount of 0 to 80 weight percent and is selected from the group consisting of talc, silica, silicate, aluminum nitride, mica, ceramic, barium titanate, and titantium dioxide;
(e) the oxygen scavengers or corrosion inhibitors are present in an amount up to 10 weight percent (but not 0%), and
(f) the adhesion promoters are present in an amount of 0 to 10 weight percent, for a total of 100 weight percent.

3. The composition according to claim 1 or claim 2 in which the oxygen scavengers are selected from the group of compounds consisting of hydroquinone. carbohydrazide, 8-hydroxyquinoline, trihydroxybenzene, aminophenol, hydrazine, pyrogallol, carbohydrazone, polyethyleneamine, cyclohexanedione, hydroxylamine, methoxypropylamine, cyclohexylamine, diethylethanolamine, hydroxyalkylhydroxylamine, tetrasubstituted phenylenediamines, morpholinohexose reductone, ketogluconates, amine bisulfites, lactone derivatives, phenol derivatives, and substituted quinolines.

4. The composition according to claim 1 or claim 2 in which the corrosion inhibitors are selected from the group of compounds consisting of 1,10-phenathiodine, phenothiazine, benzothriazole, benzimidazole, mercaptobenzothiazole , dicyandiamide, 3-isoprolyamino-1-butyne, propargyl quinolinium bromide, 3-benzylamino-1-butyne, dipropargl ether, dipropargyl thioether, propargyl caproate, dianimoheptane, phenathroline, amine, diamine, triamine, hexamethyleneimide,decamethyleneimide, hexamethyleneiminebenzoate, hexamethyleneimine-3,5-dinitrobenzoate, hexamethylenetetramin, d-oximino-b-vinyl quinuclidine, aniline, 6-N-ethyl purine, 1-ehylamino-2-octadecylimidazoline, morpholine, ethanolamine, aminophenol, 8-hydroxyquinoline, pyridine and its derivatives, quinoline and its derivatives, acridine, imidazole and its derivatives, toluidine, mercaptan, thiophenol and its derivates, sulfide, sulfoxide, thiophosphate, and thiourea.

5. A method of enhancing the electrical stability of a composition comprising adding to the composition an oxygen scavenger or corrosion inhibitor or both.
